# EUROPÄISCHE PATENTSCHRIFT

(11) **EP 1 010 223 B1**
(45) Veröffentlichungstag und Bekanntmachung des Hinweises auf die Patenterteilung: **08.05.2002**
(21) Anmeldenummer: 98948876.2
(22) Anmeldetag: 27.08.1998
(51) Int. Cl.: H01L 21/00

(54) **VERFAHREN ZUM BEHANDELN VON SUBSTRATEN**
METHOD FOR TREATING SUBSTRATES
PROCEDE DE TRAITEMENT DE SUBSTRATS

(30) Priorität: 01.09.1997 DE 19738147
(43) Veröffentlichungstag der Anmeldung: 21.06.2000
(73) Patentinhaber: STEAG MicroTech GmbH, 72124 Pliezhausen (DE)
(72) Erfinder: BIEBL, Ulrich, D-79297 Winden (DE); OSHINOWO, John, 72667 Schlaitdorf (DE)
(74) Vertreter: Wagner, Karl H., Dipl.-Ing.
(86) Internationale Anmeldenummer: EP9805444
(87) Internationale Veröffentlichungsnummer: WO9912238

(56) Entgegenhaltungen:
- WO-A-95/02473
- DE-A- 4 413 077
- US-A- 5 275 184
- US-A- 5 656 097

## Beschreibung

Die Erfindung betrifft ein Verfahren zum Behandeln von Substraten in einem ein Behandlungsfluid enthaltenden Behälter.

Verfahren dieser Art sind aus der DE 44 13 077 C oder der DE 195 46 990 C bekannt, die auf dieselbe Anmelderin wie die vorliegende Anmeldung zurückgehen, sowie in den nicht vorveröffentlichten DE 196 16 402 A, DE 196 16 400 A, DE 196 37 875 A, DE 197 22 423 A oder DE 196 44 254 A derselben Anmelderin beschrieben. Außerdem wird ein Verfahren dieser Art in WO-A-9 502 473 beschrieben. Obgleich sich diese Verfahren sehr bewährt haben, ist bei diesem Überströmverfahren viel Volumen an Behandlungsfluid erforderlich, um durch ein Verdrängungsverfahren unterschiedliche Behandlungsfluids auszutauschen, da mehrere Verdrängungszyklen und mehrere Behältervolumen erforderlich sind.

Aus der US 5 275 184 ist ein Verfahren bekannt, bei dem Kassetten mit darin enthaltenen Substraten in einem mit einem Behandlungsfluid gefüllten Behälter eingesetzt wird. Durch die Verwendung von Kassetten sind wesentlich größere Behälter und damit wesentlich größere Mengen an Behandlungsfluid erforderlich, das nicht nur als solches teuer ist, sondern auch mit großem Aufwand, beispielsweise mit teueren Crack-Verfahren, entsorgt werden müssen. Darüber hinaus ist die Behandlung der Substrate in den Kassetten nicht so gut und einfach durchführbar, wie dies in einem Behälter ohne Kassetten möglich ist, weil die Kassetten während des Behandlungsvorgangs erheblich stören. Ein weiterer, sehr großer Nachteil derartiger Verfahren besteht auch darin, daß eine gleichmäßige Behandlung über die gesamten Substratflächen hinweg und unabhängig von der Lage der Substrate innerhalb der Kassette oder des Behälters nicht möglich ist. Dies rührt daher, daß nicht nur die Kassetten selbst eine gleichmäßige Behandlung der Substrate verhindern, sondern daß die unteren Bereiche der Substrate, die zuerst in das Behandlungsfluid eingetaucht werden und beim Herausheben am längsten im Behandlungsfluid verbleiben, stärker behandelt werden als die oberen Bereiche, weil sie länger mit dem Behandlungsfluid, beispielsweise einer ätzenden Flüssigkeit, in Berührung stehen.

Die US-A-5 656 097 zeigt und beschreibt ein Verfahren und eine Vorrichtung zum Behandeln von Wafern, die in einen mit einem ersten Behandlungsfluid, beispielsweise einem Reinigungsfluid, gefüllten Behälter eingesetzt werden. Nach der Behandlung mit dem ersten Behandlungsfluid wird dieses abgelassen. In einer weiteren Behandlungssequenz wird danach ein weiteres Behandlungsfluid, nämlich ein gepuffertes Oxid-Ätzmittel (BOE) oder Flußsäure sowie deionisiertes Wasser mit hoher Strömungsrate eingelassen. Nach diesem Behandlungsvorgang wird entweder diese Behandlungsflüssigkeit abgelassen, so daß danach mit einem neuen Behandlungsfluid der Behälter gefüllt werden kann, oder der Zufluß des BOE oder der Flußsäure wird abgeschaltet und durch das noch Fließende Wasser aus getauscht.

Der Erfindung liegt die Aufgabe zugrunde, ein Verfahren zu schaffen, mit dem es möglich ist, Behälter ohne Kassetten zu verwenden, eine gleichmäßige Behandlung der Substrate sicherzustellen und/oder mit einem geringen Volumen an Behandlungsflüssigkeit auszukommen.

Diese Aufgabe wird er-findungsgemäß mit einem Verfahren zum Behandeln von Substraten in einem ein Behandlungsfluid enthaltenden Behälter gemäß Anspruch 1.

Mit dem erfindungsgemäßen Verfahren ist es möglich, mit einer geringen Menge an erstem Behandlungsfluid, beispielsweise einer Chemikalie, wie beispielsweise verdünnter Flußsäure zum Ätzen von Waferoberflächen, aus zukommen, da lediglich das Fluidvolumen entsprechend dem Behältervolumen erforderlich ist. Das vollständige Austauschen des ersten Behandlungsfluids mit einem zweiten Behandlungsfluid ist dabei mit einer geringen Menge von zweiten Behandlungsfluid möglich, weil das Entfernen des ersten Behandlungsfluids durch das Nichtvorhandensein einer Kassette wesentlich einfacher und schneller durchgeführt werden kann. Ein besonderer Vorteil des erfindungsgemäßen Verfahrens besteht insbesondere auch darin, daß die gleichmäßige Behandlung der Substrate gegenüber herkömmlichen Verfahren wesentlich besser ist, weil die unteren Bereiche der Substrate, die gemäß Verfahrensschritt b) zuerst und damit länger mit dem Behandlungsfluid in Berührung kommen bzw. stehen, durch die Einführung des zweiten Behandlungsfluids von unten auch zuerst von dem ersten Behandlungsfluid befreit werden. Entsprechend kommen die oberen Bereiche der Substrate beim Einleiten des ersten Behandlungsfluids gemäß Verfahrensschritt b) später mit ihm in Berührung und werden gemäß Verfahrensschritt c) beim Verdrängen auch später vom zweiten Behandlungsfluid ersetzt. Mit dem erfindungsgemäßen Verfahren sind also gegenüber den herkömmlichen Verfahren nicht nur Vorteile hinsichtlich der Einsparung von Prozeßmedien und der Beschleunigung der Prozeßzeit, sondern insbesondere auch hinsichtlich der gleichmäßigen Behandlung der Substrate erzielbar.

Gemäß der Erfindung werden die Verfahrensschritte b) und c) wenigstens einmal wiederholt. Das zweite Behandlungsfluid wird vor der Wiederholung der Verfahrensschritte b) und c) über eine Abflußöffnung im Behälterboden abgelassen, was schnell durchgeführt werden kann. Da danach nochmals eine Behandlung mit Behandlungsfluid erfolgt, ist ein Trocknen der Substrate in vielen Fällen zunächst nicht erforderlich. Der Trocknungsvorgang, der vorzugsweise mit dem Herausheben aus dem zweiten Behandlungsfluid und insbesondere unter Verwendung des Marangoni-Prinzips durchgeführt wird, ist erst am Ende der wiederholten Durchführung der Verfahrensschritte b) und c) durchzuführen.

Gemäß einer vorteilhaften Ausführungsform der Erfindung wird das erste Behandlungsfluid, beispielsweise ein ätzendes Fluid, einen vorgegebenen Zeitraum im Fluidbehälter belassen, um eine gewünschte Behandlung, z. B. einen gewünschten Oberflächenabtrag zu erreichen, bevor das zweite Behandlungsfluid zur Verdrängung des ersten Behandlungsfluids eingeleitet wird.

Gemäß einer besonders vorteilhaften Ausführungsform der Erfindung werden die Substrate nach Wiederholung der Schritte (b) und (c) aus dem zweiten Behandlungsfluid herausgehoben. Das zweite Behandlungsfluid ist dabei vorzugsweise ein Spülfluid, das z.B. in einer Menge eingeleitet wird, die einem vielfachen des Behältervolumens, beispielsweise dem 6- bis 18-fachen des Behältervolumens entspricht. Dadurch wird eine sichere Reinigung und Spülung der Substrate erreicht, bevor sie herausgehoben und getrocknet werden. Da das Spül- oder Reinigungsfluid sowohl hinsichtlich des Chemikaliengehalts als auch hinsichtlich der Wiederaufbereitung und Entsorgung wesentlich weniger kostenintensiv ist, ist auch eine häufige Umwälzung des Behältervolumens und damit eine zuverlässige, vollständige Reinigung der Substrate am Ende des Behandlungsvorgänge kostengünstig möglich.

Gemäß einer besonders vorteilhaften Ausführungsform der Erfindung wird während des Heraushebens der Substrate aus dem zweiten Behandlungsfluid ein einen Trocknungsvorgang verbesserndes Fluid gemäß dem Marangoni-Prinzip auf die Oberfläche des zweiten Behandlungsfluids geleitet. Um hinsichtlich dieses Trocknungsverfahrens Wiederholungen zu vermeiden, wird auf die EP 0 385 536 A sowie auf die DE 44 13 077 C derselben Anmelderin verwiesen.

Bei der Wiederholung der Verfahrensschritte b) und c) erfolgt die Behandlung der Substrate vorzugsweise mit unterschiedlichen Behandlungsfluids. Wie dies im nachfolgenden anhand von Ausführungsbeispielen noch im einzelnen erläutert werden wird, wird zunächst bei Abfolge der Verfahrensschritte a), b) und c) eine Behandlung mit einer Ätzflüssigkeit, beispielsweise mit Flußsäure, vorgenommen, und bei Wiederholung der Verfahrensschritte b) und c) wird ein Ammoniak-Wasserstoffperoxid-Wassergemisch verwendet, und gegebenenfalls dieses Bad bzw. die Substrate mit Megaschall bestrahlt.

Gemäß einer weiteren sehr vorteilhaften Ausführungsform der Erfindung werden die Substrate vor dem Einsetzen in den Behälter gemäß Verfahrensschritt a) in wenigstens einem weiteren Behälter vorbehandelt. Obgleich für den weiteren Behälter auch ein Behälter mit integrierten Führungen für die Substrate, also ein kassettenloser Behälter geeignet sein kann, ist gemäß einer weiteren vorteilhaften Ausführungsform der Erfindung der weitere Behälter zur Aufnahme einer Kassette mit dem darin enthaltenen Substraten ausgebildet. Dies ist insbesondere dann vorteilhaft, wenn die Behandlung der Substrate in dem weiteren Behälter mit sehr aggressiven Chemikalien, beispielsweise sehr heißer Phosphorsäure oder heißen Flußsäuren, etwa zum Entfernen von Photolack durchgeführt werden soll. Bei Verwendung aggressiver Chemikalien sind besondere Behältermaterialien, wie beispielsweise Quarz erforderlich, während die Fluidbehälter für die nachfolgenden Verfahrensabläufe vorzugsweise aus kostengünstigeren Materialien, wie beispielsweise Kunststoff oder mit einer Auflage versehenem Kunststoff bestehen. Durch die heißen Chemikalien, die teilweise Temperaturen bis 200 °C aufweisen können, treten im Behälter auch Materialausdehnungen auf, die das Haltern der Substrate in Kassetten erforderlich machen. Die für die Halterung von Substraten in beckeneigenen Führungselementen erforderlichen genauen Maßeinhaltungen können dabei nicht gewährleistet werden.

Die Erfindung wird nachstehend anhand bevorzugter Ausführungsbeispiele unter Bezugnahme auf die Figuren näher erläutert. Es zeigen:
- Fig. 1: eine schematische Darstellung eines nicht erfindungsgemäßen Verfahrens,
- Fig. 2: eine schematische Darstellung eines ersten Auführungsbeispiels des erfindungsgemäßen Verfahrens,
- Fig. 3: eine schematische Darstellung eines zweiten Ausführungsbeispiels des erfindungsgemäßen Verfahrens,
- Fig. 4: eine schematische Darstellung eines dritten Ausführungsbeispiels des erfindungsgemäßen Verfahrens und
- Fig. 5: eines wierten Ausführungsbeispiels des erfindungsgemäßen Verfahrens.

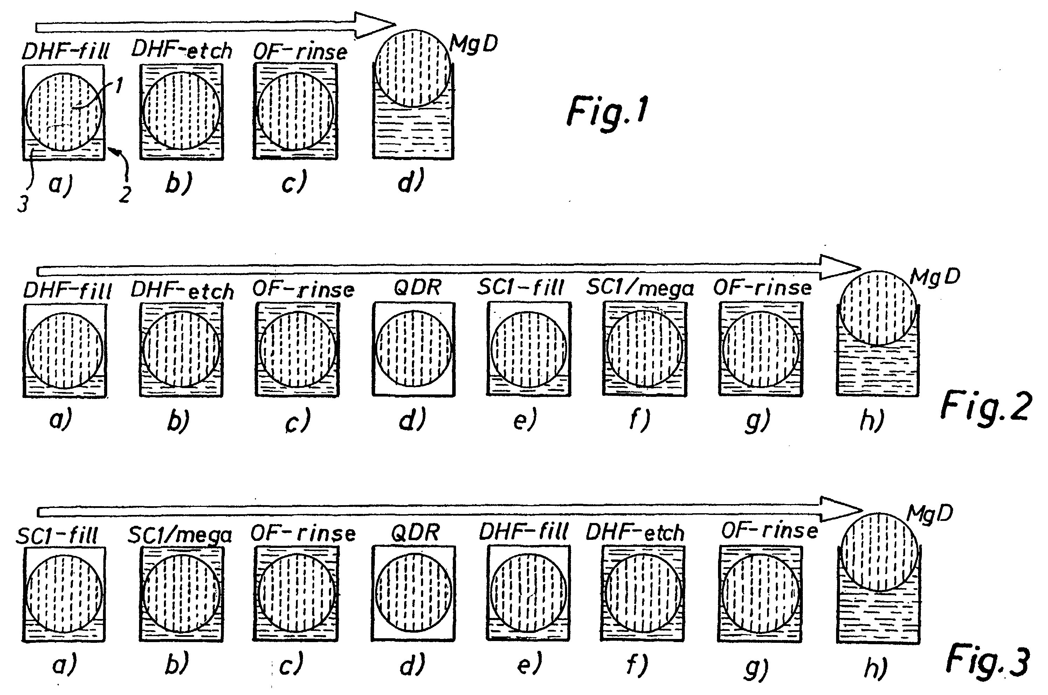

Bei dem in Fig. 1 dargestellten Verfahren werden Substrate 1, beispielsweise Halbleiterwafer, in einen leeren Fluidbehälter 2 eingesetzt und danach wird gemäß dem Verfahrensschritt a) von unten ein erstes Behandlungsfluid 3, z. B. verdünnte Flußsäure, in den Fluidbehälter 2 eingelassen, wie dies durch den unteren schwarzen Bereich innerhalb des Fluidbehälters 2 angedeutet und mit DHF-fill bezeichnet ist.

Gemäß des Verfahrensschritts b) ist der Behälter 2 vollständig mit dem von unten eingelassenen ersten Behandlungsfluid 3 gefüllt und die Substrate 1 werden während dieses Verfahrensschrittes b) behandelt. Dieser Verfahrensschritt wird in den Figuren mit DHF-etch bezeichnet, d. h. die Substrate werden mit Flußsäure geätzt.

Während des nachfolgenden Behandlungsschrittes c) wird ein zweites Fluid, z. B. Spülfluid, von unten in den Fluidbehälter 2 eingelassen und dadurch die Flußsäure durch Überströmen verdrängt, was in Fig. 1 c mit OF-rinse bezeichnet ist. Im nachfolgenden Verfahrensschritt d) ist schematisch angedeutet, daß die Substrate 2 aus dem Fluidbehälter 2 herausgehoben und getrocknet werden. Durch den Hinweis MgD wird auf die Marangoni-Trocknung hingewiesen.

Bei dem in Fig. 1 schematisch angedeuteten Fluidbehälter 2 handelt es sich um einen sogenannten Single Tank Tool (STT), bei dem Fluid von unten eingeleitet wird und an der Fluidoberfläche bzw. über die Behälter-Oberkante abfließt. Die Substrate 1 werden dabei innerhalb des Fluidbehälters 2 durch Führungen geführt und gehalten, die von wenigstens einer Behälter-Seitenwand nach innen abstehen. Um Wiederholungen hinsichtlich derartiger Fluidbehälter 2 und deren Ausführungsformen und Funktionsweisen zu vermeiden, wird insbesondere auf die DE 196 16 402 A, die DE 197 22 423, die DE 196 44 253 A, die DE 196 44 254 A oder die DE 196 44 255 A derselben Anmelderin verwiesen.

Bei dem dargestellten Verfahren wurde als erstes Behandlungsfluid verdünnte Flußsäure beispielsweise in einer Konzentration von 0,1 bis 1 % verwendet. Die Füllmenge des Fluidbehälters 2 beträgt beispielsweise bei 200 mm-Wafern 8,5 Liter. Dies ist im Vergleich zu herkömmlichen Fluidbehältern mit in Kassetten eingesetzten Wafern sehr wenig, so daß teures Behandlungsfluid nur in geringen Mengen erforderlich ist. Die Spülflüssigkeit gemäß dem Überström-Spülschritt c) ist vorzugsweise deionisiertes Wasser und wird beispielsweise mit einem Volumen, das dem sechsfachen des Fluidbehälters 2 entspricht, also in einer Menge von 50 Liter eingeleitet, und zwar vorzugsweise innerhalb einer Minute. Das Verfahren ermöglicht daher eine sehr schnelle Verdrängung auch durch das geringe Behältervolumen, so daß dadurch die Behandlungszeit und damit die Produktivität des Verfahrens hoch ist.

Wie dies aus den Verfahrensschritten a) und b) von Fig. 1 ersichtlich ist, ergibt sich auch eine sehr gleichmäßige Behandlung der Substrate 1, was für die Behandlungs- und Herstellungsverfahren von Halbleiterbauelementen und Wafern besonders wichtig ist. Beim Einlassen der verdünnten Flußsäure von unten in den Fluidbehälter 2 gemäß Verfahrensschritt a) kommen zunächst die unteren Bereiche des Substrats 1 mit der Flußsäure 3 in Berührung, so daß in den unteren Bereichen graduell nach oben abnehmend von den Substratoberflächen mehr abgeätzt wird als von den oberen Bereichen der Substrate 1. Durch die Verdrängung der verdünnten Flußsäure mittels der Spülflüssigkeit von unten her während des Verfahrensschritts c) wird jedoch bewirkt, daß die unteren Bereiche früher von der ätzenden Flußsäure freikommen als die oberen Bereiche, so daß dadurch die beim Einleiten der Flußsäure gemäß Verfahrensschritt a) vorliegenden Gegebenheiten kompensiert werden. Dadurch ergeben sich über die gesamte Substratfläche hinweg gleichförmige Behandlungsergebnisse. Insbesondere ist es mit dem Verfahren auch möglich, durch Einstellung der Geschwindigkeit, mit der die Spülflüssigkeit 4 gemäß Verfahrensschritt c) von unten in den Fluidbehälter 2 eingeleitet wird, die gleichförmige Behandlung der Substrate zu steuern und zu regeln, d. h. sicherzustellen, daß die verdünnte Flußsäure an allen Bereichen der Substrate 1 gleich lang wirkt.

Die in Fig. 1 dargestellten Symbole für die Verfahrensschritte a) bis d) werden in den nachfolgenden Figuren mit derselben Bedeutung verwendet.

Der in Fig. 2 dargestellte Verfahrensablauf ist hinsichtlich der Verfahrensschritte a), b) und c) mit dem Verfahrensablauf gemäß Fig. 1 identisch. Statt des Verfahrensschrittes d) in Fig. 1 folgt dem Verfahrensschritt c) bei dieser Ausführungsform des Verfahrens ein Verfahrensschritt d), der mit QDR (Quick Dump Rinse) bezeichnet ist, und bei dem die Spülflüssigkeit nach dem Verdrängungs- und Spülprozeß gemäß dem vorausgegangenen Verfahrensschritt c) über eine Abflußöffnung im Boden des Fluidbehälters 2 schnell abgelassen werden kann, so daß der Behälter 2 leer ist, wie dies durch die Darstellung des Verfahrensschritts d) in Fig. 2 schematisch dargestellt ist. Dadurch ist es nunmehr möglich, die Verfahrensschritte a), b) und c) gemäß Fig. 2 für ein anderes Behandlungsfluid zu wiederholen.

Während des Verfahrensschritts e) wird ein weiteres Behandlungsfluid, im vorliegenden Falle eine Mischung aus Ammoniak, Wasserstoff-Peroxid und Wasser (mit SC1-fill bezeichnet), zur intensiven Reinigung der Substrate 1 von unten in den Fluidbehälter 2 eingeleitet und gemäß Verfahrensschritt f) über einen bestimmten Zeitraum hinweg mit den Substraten 1 in Berührung gelassen. Gleichzeitig wird gemäß diesem Ausführungsbeispiel eine Megaschall-Beschallung der Substrate vorgenommen, mit der der Reinigungsvorgang noch verbessert wird.

An diesen Reinigungsvorgang schließt sich der zweite Spülvorgang g) an, der dem zuvor bereits ausgeführten Spülvorgang d) entspricht. Nach vollständiger Reinigung und Spülung wird der Vorgang h) durchgeführt, der entsprechend dem gleichen Symbol wie beim Vorgang d) von Fig. 1 wiederum die Marangoni-Trocknung betrifft.

Die Verfahrensabfolge gemäß Fig. 3 unterscheidet sich von der Abfolge gemäß Fig. 2 lediglich dadurch, daß zunächst die Reinigung mit dem Gemisch aus Ammoniaksäure, Wasserstoffperoxid und Wasser und danach erst die Behandlung mit verdünnter Flußsäure durchgeführt wird. Das heißt, die in Fig. 2 symbolisch dargestellten Verfahrensschritte a), b), c) wurden mit den Verfahrensschritten e), f) und g) vertauscht.

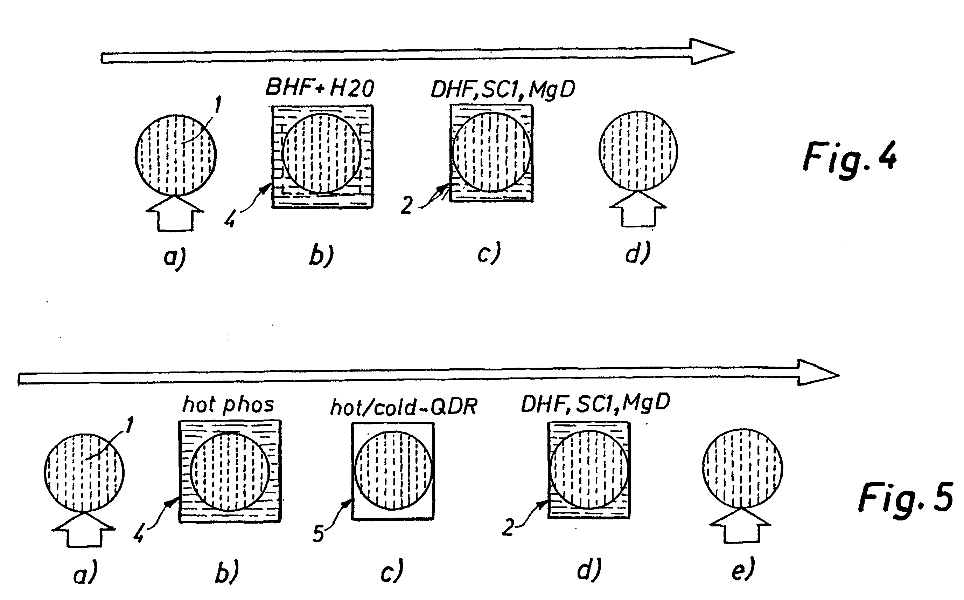

Fig. 4 zeigt eine Ausführungsform des erfindungsgemäßen Verfahrens, bei dem den Prozeßfolgen gemäß den Fig. 2 bzw. 3 ein Behandlungsvorgang vorgeschaltet ist, der in einem für die Aufnahme von Wafern in einer Kassette ausgebildeten Behälter 4 durchgeführt wird. Bei dem schematisch angedeuteten Verfahrensschritt a) werden die Wafer mit einem an sich bekannten Manipulator in eine Kassette gegeben. Die mit Wafern gefüllte Kassette wird in den Kassetten-Fluidbehälter 4 eingesetzt, wie dies gemäß Verfahrensschritt b) symbolisch angedeutet ist, bei dem die Substrate 1 nicht mit den Behälterseitenwänden in Berührung stehen. Der Behälter 4 ist bzw. wird mit einem Behandlungsfluid gefüllt, das hinsichtlich der Beständigkeit an den Fluidbehälter 4 besondere Anforderungen stellt. Bei dem dargestellten Ausführungsbeispiel wird gepufferte Flußsäure (in Fig. 4 mit BHF + H2O angedeutet) verwendet, die ein haltbares Material für den Behälter erfordert. Darüber hinaus kristallisiert die Flüssigkeit aus, so daß besondere Einlaßöffnungen zum Einlassen dieses Behandlungsfluids erforderlich sind und der für die weiteren Behandlungsvorgänge verwendete, vorteilhafte Fluidbehälter mit kassettenloser Waferführung auch deshalb nicht verwendet werden kann, weil durch das Auskristallisieren die dort verwendeten für die weiteren Verfahrensvorgänge sehr vorteilhaften Fluideinlaßdüsen verstopfen würden.

Bei dem Verfahrensschritt c) von Fig. 4 sind die Verfahrensschritte a), b), c) und h) gemäß den Fig. 2 bzw. 3 zusammengefaßt symbolisiert dargestellt, um Wiederholungen zu vermeiden. Die einzelnen Verfahrensweisen sind symbolhaft durch die Bezeichnungen DHF, SC1 und MgD angegeben. Zwischen dem Behandlungschritt b) und c) erfolgt ein Umhorden der Substrate 1 aus dem Behälter 4 bzw. aus einer Kassette in den kassettenfreien Behälter 2 beispielsweise mit einer Handhabungseinrichtung, wie sie in der nicht vorveröffentlichten DE 196 52 526 A derselben Anmelderin beschrieben ist.

Der Verfahrensschritt d) in Fig. 4 symbolisiert das Herausführen der fertig behandelten Substrate aus dem Behandlungsprozeß.

Fig. 5 zeigt eine weitere Ausführungsform der Erfindung, die sich gegenüber der in Fig. 4 dargestellten Ausführungsform lediglich dadurch unterscheidet, daß ein dritter Fluidbehälter 5 in der Verfahrensabfolge zwischen dem eine Kassette aufnehmenden Behälter 4 und dem kassettenlosen Behälter 2, d. h. zwischen den Verfahrensschritten b) und c) von Fig. 4, vorgesehen ist. Der dritte Behälter 5 ist bei dem dargestellten Ausführungsbeispiel - wie dies durch die symbolhafte Darstellung angedeutet ist - ein kassettenfreier Behälter, bei dem die Substrate 1 in Führungen der Behälterwand geführt und gehalten sind.

Während des Verfahrensschritts b) werden die Substrate z. B. mit heißer Phosphorsäure (mit "hot phos" bezeichnet) behandelt. Die Angabe "hot/cold-QDR" bei Verfahrensschritt c) bedeutet das Spülen mit heißen und/oder kalten Spülflüssigkeiten bei schnellem Fluidablaß, wie dies z. B. in der DE 196 16 402 A beschrieben ist.

Der dritte Behälter 5 ist dafür vorgesehen, durch schnelles Füllen und Entleeren, also nicht durch ein Überströmverfahren, die Substrate mit heißem und/oder kaltem Spülund/oder Reinigungsfluid zu reinigen und/oder zu spülen. Der dritte Behälter 5 dient also im wesentlichen lediglich als Spülbecken, wobei das Behältermaterial vorzugsweise so gewählt ist, daß er auch-heißen Spül- oder Behandlungsfluid standhält.

Die Erfindung wurde zuvor anhand bevorzugter Ausführungsbeispiele erläutert. Dem Fachmann sind jedoch zahlreiche Abwandlungen und Ausgestaltungen möglichst, ohne daß dadurch der Erfindungsgedanke verlassen wird. Obgleich das erfindungsgemäße Verfahren im Zusammenhang mit 200 mm (8-Zoll)-Wafern beschrieben wurde, ist es insbesondere auch für 300 mm-Wafer vorteilhaft anwendbar, weil bei derartig großen Wafern die gleichförmige Behandlung besonders schwierig und durch die größeren Fluidbehälter eine Einsparung an Behandlungsfluid um so wichtiger ist.

## Patentansprüche

1. Verfahren zum Behandeln von Substraten mit wenigstens einem ersten und zweiten Behandlungsfluid nacheinander in einem einzigen Behälter, in dem die Substrate von an wenigstens einer Behälter-Innenwand vorgesehenen Führungen geführt und gehalten werden, wobei die Behandlungsfluids von unten eingeleitet werden und über einen Behälterrand ablaufen, mit folgenden Verfahrensschritten:
a) Einsetzen der Substrate in den leeren Behälter,
b) Einleiten eines ersten Behandlungsfluids von unten in den Fluidbehälter zum Füllen desselben und
c) Verdrängen des ersten Behandlungsfluids aus dem Fluidbehälter durch Einleiten des zweiten Behandlungsfluids von unten in den selben Fluidbehälter,
wobei die Verfahrensschritte b) und c) wenigstens einmal wiederholt werden, und das zweite Behandlungsfluid vor der Wiederholung der Verfahrensschritte b) und c) über eine Abflußöffnung im Behälterboden abgelassen wird, und wobei das zweite Behandlungsfluid ein Reinigungsfluid ist.

2. Verfahren nach Anspruch 1, **dadurch gekennzeichnet, daß** das erste Behandlungsfluid einen vorgegebenen Zeitraum im Fluidbehälter belassen wird, bevor das zweite Behandlungsfluid zur Verdrängung des ersten Behandlungsfluids eingeleitet wird.

3. Verfahren nach Anspruch 1 oder 2, **dadurch gekennzeichnet, daß** nach Wiederholung der Schritte (b) und (c) die Substrate aus dem zweiten Behandlungsfluid herausgehoben werden.

4. Veflahren nach Anspruch 3, **dadurch gekennzeichnet, daß** während des Heraushebens der Substrate aus dem zweiten Behandlungsfluid ein einen Trocknungsvorgang verbesserndes Fluid gemäß dem Marangoni-Prinzip auf die Oberfläche des zweiten Behandlungsfluids geleitet wird.

5. Verfahren nach einem der vorhergehenden Ansprüche, **dadurch gekennzeichnet, daß** die Wiederholung der Verfahrensschritte b) und c) mit unterschiedlichen Behandlungsfluids erfolgt.

6. Verfahren nach einem der vorhergehenden Ansprüche, **dadurch gekennzeichnet, daß** das zweite Behandlungsfluid in einer Menge eingeleitet wird, die einem Vielfachen des Behältervolumens entspricht.

7. Verfahren nach einem der vorhergehenden Ansprüche, **dadurch gekennzeichnet, daß** das zweite Behandlungsfluid ein Spülfluid ist.

8. Verfahren nach einem der vorhergehenden Ansprüche, **dadurch gekennzeichnet, daß** die Substrate vor dem Einsetzen in den Behälter in wenigstens einem weiteren Behälter behandelt werden.

9. Verfahren nach Anspruch 8, **dadurch gekennzeichnet, daß** der weitere Behälter zur Aufnahme einer Kassette mit darin enthaltenen Substraten ausgebildet ist.

10. Verfahren nach Anspruch 8 oder 9, **dadurch gekennzeichnet, daß** der weitere Behälter aus einem Material besteht, das aggressiven Chemikalien, insbesondere heißer Phosphor- oder Flußsäure, standhält.

11. Verfahren nach einem der vorhergehenden Ansprüche, **dadurch gekennzeichnet, daß** die zu behandelnden Substrate Halbleiterwafer sind, und das erste Behandlungsfluid verdünnte Flußsäure oder eine Mischung aus Ammoniaksäure, Wasserstoff-Peroxid und Wasser ist.

## Claims

1. Method of treating substrates by at least one first and second treatment fluid in succession in a single container, in which the substrates are guided and held by guides provided at at least one container inner wall, wherein the treatment fluids are introduced from below and run out over a container edge, with the following method steps:
a) insertion of the substrates into the empty container,
b) introduction of a first treatment fluid from below into the fluid container for the filling of the same and
c) displacing the first treatment fluid out of the fluid container by introduction of the second treatment fluid from below into the same fluid container,
wherein the method steps b) and c) are repeated at least once and the second treatment fluid is drained off by way of an outflow opening in the container base befam repetition of the method steps b) and c) and wherein the second treatment fluid is a cleaning fluid.

2. Method according to claim 1, **characterised in that** the first treatment fluid is left in the fluid container for a predetermined period of time before the second treatment fluid is introduced for displacement of the first treatment fluid.

3. Method according to claim 1 or 2, **characterised in that** after repetition of the steps b) and c) the substrates are lifted out of the second treatment fluid.

4. Method according to claim 3, **characterised in that** during the lifting of the substrates out of the second treatment fluid a fluid improving a drying process according to the Marangoni principle is conducted onto the surface of the second treatment fluid.

5. Method according to one of the preceding claims, **characterised in that** the repetition of the method steps b) and c) is carried out with different treatment fluids.

6. Method according to one of the preceding claims, **characterised in that** the second treatment fluid is introduced in a quantity corresponding to a multiple of the container volume.

7. Method according to one of the preceding claims, **characterised in that** the second treatment fluid is a washing fluid.

8. Method according to one of the preceding claims, **characterised in that** the substrates are treated in at least one further container before insertion into the container.

9. Method according to claim 8, **characterised in that** the further container is constructed for reception of a cassette with substrates contained therein.

10. Method according to claim 8 or 9, **characterised in that** the further container consists of a material which resists aggressive chemicals, particularly hot phosphoric or hydrofluoric acids.

11. Method according to one of the preceding claims, **characterised in that** the substrates to be treated are semi-conductor wafers and the first treatment is dilute hydrofluoric

## Revendications

1. Procédé de traitement de substrats avec au moins un premier et un second fluide de traitement successivement dans un seul récipient, dans lequel les substrats sont guidés et maintenus par des guidages prévus à au moins une paroi intérieure de récipient, où les fluides de traitement sont introduits depuis en dessous et s'écoulent par dessus un bord du récipient, comprenant les étapes de procédé suivantes :
a) mise en place des substrats dans le récipient vide,
b) introduction d'un premier fluide de traitement depuis en dessous dans le récipient de fluide pour remplir celui-ci et
c) refoulement du premier fluide de traitement du récipient de fluide par l'introduction du second fluide de traitement depuis en dessous dans le même récipient de fluide,
où les étapes de procédé b) et c) sont répétées au moins une fois, et où le second fluide de traitement, avant la répétition des étapes de procédé b) et c) est évacué par une ouverture d'écoulement dans le fond du récipient, et où le second fluide de traitement est un fluide de nettoyage.

2. Procédé selon la revendication 1, **caractérisé en ce que** le premier fluide de traitement reste pendant un lapse de temps prédéterminé dans le récipient de fluide avant que le second fluide de traitement soit introduit pour refouler le premier fluide de traitement.

3. Procédé selon la revendication 1 ou 2, **caractérisé en ce que**, après la répétition des étapes b) et c), les substrats sont relevés et sortis du second fluide de traitement.

4. Procédé selon la revendication 3, **caractérisé en ce que** pendant la sortie des substrats du second fluide de traitement, un fluide améliorant l'opération de séchage, selon le principe de Marangoni, est guidé sur la surface du second fluide de traitement.

5. Procédé selon l'une des revendications précédentes, **caractérisé en ce que** la répétition des étapes de procédé b) et c) a lieu avec des fluides de traitement différents.

6. Procédé selon l'une des revendications précédentes, **caractérisé en ce que** le second fluide de traitement est introduit en une quantité qui correspond à un multiple du volume du récipient.

7. Procédé selon l'une des revendications précédentes, **caractérisé en ce que** le second fluide de traitement est un fluide de rinçage.

8. Procédé selon l'une des revendications précédentes, **caractérisé en ce que** les substrats, avant la mise en place dans le récipient, -sont traités au moins dans un autre récipient.

9. Procédé selon la revendication 8, **caractérisé en ce que** le récipient additionnel est réalisé pour la réception d'une cassette avec les substrats qu'elle contient.

10. Procédé selon la revendication 8 ou 9, **caractérisé en ce que** le récipient additionnel est réalisé en un matériau qui résiste à des produits chimiques agressifs, notamment à de l'acide phosphorique ou acide fluorhydrique chaud.

11. Procédé selon l'une des revendications précédentes, **caractérisé en ce que** les substrats à traiter sont des plaquettes de semiconducteur, et le premier fluide de traitement est de l'acide fluorhydrique dilué ou un mélange d'acide ammoniaque, de peroxyde d'hydrogène et d'eau.
